# EUROPEAN PATENT SPECIFICATION

(11) **EP 4 174 017 B1**
(45) Date of publication and mention of the grant of the patent: **25.02.2026**
(21) Application number: 20943724.3
(22) Date of filing: 28.06.2020
(51) Int. Cl.: B81B 5/00, C23C 16/44, C10M 103/02

(54) **STRUCTURAL SUPERLUBRICITY DEVICE CAPABLE OF REDUCING EDGE FRICTION**
STRUKTURELLE SUPERLUBRIZITÄTSVORRICHTUNG ZUR REDUZIERUNG DER KANTENREIBUNG
DISPOSITIF À SUPER-POUVOIR LUBRIFIANT STRUCTURAL POUVANT RÉDUIRE LE FROTTEMENT DE BORD

(43) Date of publication of application: 03.05.2023
(73) Proprietor: Research Institute of Tsinghua University in Shenzhen, Shenzhen, Guangdong 518057 (CN); Tsinghua University, Haidian District, Beijing 100084 (CN)
(72) Inventor: ZHENG, Quanshui, Beijing 100084 (CN); XIANG, Xiaojian, Beijing 100084 (CN)
(74) Representative: Prinz & Partner mbB
(86) International application number: PCT/CN2020/098478
(87) International publication number: WO 2022/000121

(56) References cited:
- CN-A- 1 714 309
- CN-A- 103 438 348
- CN-A- 107 740 069
- CN-A- 108 799 127
- CN-U- 209 281 399
- JP-A- 2004 306 763
- US-A1- 2015 197 701
- DATABASE WPI Week 201509, Derwent World Patents Index; AN 2015-05974U, XP002810824
- HAN EDMUND ET AL: "Ultrasoft slip-mediated bending in few-layer graphene", NATURE MATERIALS, NATURE PUBLISHING GROUP UK, LONDON, vol. 19, no. 3, 11 November 2019 (2019-11-11), pages 305 - 309, XP037523391, ISSN: 1476-1122, [retrieved on 20191111], DOI: 10.1038/S41563-019-0529-7
- HUANG RUI: "Bending with slip", NATURE MATERIALS, NATURE PUBLISHING GROUP UK, LONDON, vol. 19, no. 3, 25 February 2020 (2020-02-25), pages 259 - 260, XP037050064, ISSN: 1476-1122, [retrieved on 20200225], DOI: 10.1038/S41563-020-0604-0
- DUAN YICHEN ET AL: "Deposition of copper from Cu(I) and Cu(II) precursors onto HOPG surface: Role of surface defects and choice of a precursor", vol. 146, no. 5, 8 December 2016 (2016-12-08), US, XP093119475, ISSN: 0021-9606, Retrieved from the Internet <URL:https://pubs.aip.org/aip/jcp/article-pdf/doi/10.1063/1.4971287/13397267/052814_1_online.pdf> [retrieved on 20240214], DOI: 10.1063/1.4971287

## Description

### TECHNICAL FIELD

The present invention relates to the field of structural superlubricity and, in particular, to a structural superlubric device capable of reducing edge friction.

### BACKGROUND

For a long time, the problem of friction and wear not only closely relates to manufacturing but also directly relates to energy, environment, and health. According to statistics, friction dissipates about one third of the energy in the world, and around 80% of the failure of machine components result from wear. Structural superlubricity (SSL) technology is one of the ideal solutions to solve the problem of friction and wear. The SSL is the state of nearly vanishing friction and no wear between two van der Waals solid surfaces (such as surfaces of graphene, molybdenum disulfide and other two-dimensional materials) that are smooth in atomic scale and in incommensurate contact with each other. In 2004, the research group of Prof. J. Frenken measured the friction force between a graphite slice with a size of a few nanometers (about 100 carbon atoms in total) stuck on a probe, and a crystal plane of highly oriented pyrolytic graphite (HOPG), and provided the first experimental confirmation of the existence of nanoscale superlubricity. However, a nanoscale contact surface is pretty small in comparison to the scale required in practical application. Apart from a macroscale contact surface, even the contact surface of the finest bearing in the most sophisticated mechanical watch has a scale of several hundred microns. How to achieve large-scale structural superlubricity had become a challenge for scientists, but the structural superlubricity could still be observed under the conditions of a nanoscale, a high vacuum environment, and a low speed. In 2012, Ze Liu and Quanshui Zheng, et al. realized the structural superlubricity at a micron scale for the first time, and confirmed that the friction force in a micrometer-scale graphite mesa obviously has the basic characteristics of structural superlubricity by using HOPG to design the experiment of the "self-retracting motion" of graphite mesas.

Currently, most of the existing HOPG-based structural superlubric devices are in the shape of flakes or mesas. When the lower surface of a flake-shaped or mesa-shaped graphite slice moves relative to a substrate, an interfacial chemical bond between the edge of the lower surface of the graphite slice and the substrate leads to extremely low friction. People aim to eliminate the friction due to the interfacial chemical bond between the edge of the graphite slice and the substrate and better reduce the total friction between the graphite slice and the substrate. However, this technical problem and the solution to the problem have not been proposed yet in the existing art.

WO 2015/003343 A1 describes superlubricity basic structure, multi-stage superlubricity structure, device with structure, and forming method therefor.

HAN EDMUND ET AL: "Ultrasoft slip-mediated bending in few-layergraphene", NATURE MATERIALS, NATURE PUBLISHING GROUP UK, LONDON, vol. 19, no. 3, 11 November 2019 (2019-11-11), pages 305-309, XP037523391, ISSN: 1476-1122, DOI: 10.1038/S41563-019-0529-7XP037523391 describes ultrasoft slip-mediated bending in few-layer graphene

HUANG RUI: "Bending with slip", NATURE MATERIALS, NATURE PUBLISHING GROUP UK, LONDON, vol. 19, no. 3, 25 February 2020 (2020-02-25), pages 259-260, XP037050064, ISSN: 1476-1122, DOl: 10.1038/S41563-020-0604-0 describes bending with slip.

Duan Yichen ET AL: "Deposition of copper from Cu(I) and Cu(ll) precursors onto HOPG surface: Role of surface defects and choice of a precursor", The Journal of Chemical Physics, vol. 146, no. 5, 8 December 2016 (2016-12-08), XP93119475, US ISSN: 0021-9606, DOI: 10.1063/1.4971287 describes the deposition of copper from Cu(I) and Cu(ll) precursors onto HOPG surface.

### SUMMARY

In view of the shortcomings in the existing art, an object of the present invention is to provide a structural superlubric device capable of reducing edge friction, where the structural superlubric device is part of a superlubric slider and includes a superlubric slice and/or a thin film, and an edge of the superlubric slice warps along a direction opposite to a superlubric surface of the superlubric slice. The structural superlubric device is manufactured by the following method: a single layer or multiple layers of thin-film material may be deposited on a surface of the superlubric slice, where the single layer or multiple layers of thin-film material are controlled by controlling physical and chemical conditions for deposition of the thin film such that the single layer or multiple layers of thin-film material exhibit a state of tensile stress and the edge of the superlubric slice warps upwards under the action of the tensile stress.

The object of the present invention is achieved by a structural superlubric device according to claim 1.

According to another aspect of the present invention, the thin film includes a single thin film or multiple thin films.

According to another aspect of the present invention, a material of the thin film includes a metal, a metal oxide, an oxide dielectric film, a nitride dielectric film, various ceramic materials, or a polymer material.

According to another aspect of the present invention, the thin film is in the shape of a circular ring, a ring of circular arcs, a cross, a square, or a square of strips.

According to another aspect of the present invention, the superlubric slice uses graphite, HOPG, graphene, molybdenum disulfide, bismuth, molybdenum, or mica as a substrate.

According to another aspect of the present invention, the superlubric slice is an HOPG superlubric slice, or a superlubric slice including a single layer or multiple layers of two-dimensional material having smooth surfaces in atomic scale.

According to another aspect of the present invention, the two-dimensional material is graphene.

The present invention completely eliminates the friction due to an interfacial chemical bond between the edge of the superlubric slice and a substrate, greatly reduces the total friction between the superlubric slice and the substrate, and achieves a coefficient of friction at a scale of one part in ten thousand. Additionally, in the present invention, internal stress is used for controlling the edge of a graphite slice to warp and the method is simple and has high feasibility.

### BRIEF DESCRIPTION OF DRAWINGS

### DESCRIPTION OF DRAWINGS

FIG. 1 is a schematic diagram of a structural superlubric device capable of reducing edge friction according to embodiment one of the present invention.
FIG. 2 is a schematic diagram of a structural superlubric device capable of reducing edge friction according to embodiment two of the present invention.
FIG. 3 is a schematic diagram of a structural superlubric device capable of reducing edge friction according to embodiment three of the present invention.
FIG. 4 is a schematic diagram of a structural superlubric device capable of reducing edge friction according to embodiment four of the present invention.
FIG. 5 is a schematic diagram of a structural superlubric device capable of reducing edge friction according to embodiment five of the present invention.
FIG. 6 is a schematic diagram of a structural superlubric device capable of reducing edge friction according to embodiment six of the present invention.

### Reference list

- 1: superlubric slice
- 2: thin film in the shape of a circular ring
- 3: thin film in the shape of a ring of circular arcs
- 4: thin film in the shape of a cross
- 5: thin film in the shape of a square
- 6: thin film in the shape of a square of strips

### BEST EMBODIMENTS FOR IMPLEMENTING THE INVENTION

### BEST EMBODIMENTS OF THE INVENTION

A structural superlubric device of the present invention is described in detail below with reference to the drawings. Examples of embodiments are illustrated in the drawings, where the same or similar reference numerals denote the same or similar elements or elements having the same or similar functions. The embodiments described below with reference to the drawings are illustrative and intended to explain the present invention and not to limit the present invention. Many different embodiments or examples are provided below for implementing different structures of the present invention. To simplify the disclosure of the present invention, components and configurations in particular examples are described hereinafter, which, of course, are illustrative and are not intended to limit the present invention. Additionally, reference numbers and/or letters may be repeated in different examples of the present invention. Such repetition is for the sake of simplicity and clarity and does not indicate the relationship between the embodiments and/or configurations discussed. Additionally, the present invention provides examples of particular processes and materials, but those of ordinary skill in the art can conceive the applicability of other processes and/or the use of other materials. Moreover, the following structure where a first feature is "on" or "above" a second feature may include an embodiment where the first feature is in direct contact with the second feature and an embodiment where another feature is formed between the first feature and the second feature, which may not be in direct contact.

A superlubric slice in the present invention is part of a superlubric slider in the existing art. During relative sliding between two superlubric contact surfaces of existing superlubric sliders, the friction is almost zero, a coefficient of friction is less than one thousandth, and the wear is zero.

For example, an existing method for manufacturing the superlubric slice based on HOPG is specifically described below.

In step 1, the HOPG is covered with a photoresist. For example, the HOPG is covered by the photoresist through spin-coating.

In step 2, the photoresist is patterned and multiple photoresist mesas are retained. The step of patterning the photoresist determines the layout of graphite mesas formed in the subsequent steps. For example, the photoresist may be patterned by an electron beam etching method, an average diameter of the formed photoresist mesas may be, for example, 1 µm to 30 µm, and an average interval between the photoresist mesas is 1 µm to 100 µm so that the etched graphite mesas also have corresponding average diameter and average interval.

In step 3, a substrate is etched, and part of the substrate that is not protected by the photoresist is removed, so as to form multiple graphite mesas. The substrate may be etched, for example, through reactive-ion etching.

In step 4, the multiple graphite mesas are cleaved one by one by a mechanical arm to check whether the graphite mesas have superlubric shear surfaces. Among the graphite mesas with self-healing properties, an HOPG slice whose lower surface is a superlubric shear surface is the superlubric slice.

### INVENTIVE EMBODIMENTS

### EMBODIMENTS OF THE PRESENT INVENTION

The present invention is described in detail below through drawings and embodiments.

### Embodiment one

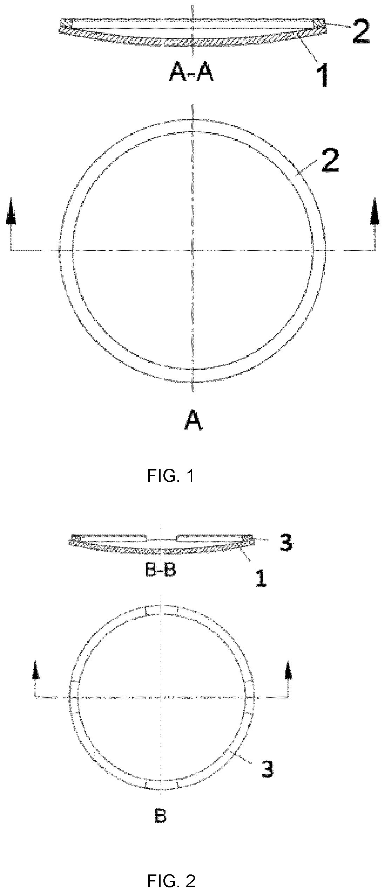

As shown in FIG. 1, a structural superlubric device capable of reducing edge friction includes a superlubric slice 1, and a thin film 2 in the shape of a circular ring and deposited on the superlubric slice 1. The superlubric slice may be an HOPG superlubric slice, or may be a superlubric slice including a single layer or multiple layers of two-dimensional material such as graphene, where the single layer or multiple layers of two-dimensional material have smooth surfaces in atomic scale. The thin film 2 may include a single thin film or multiple thin films and generally exhibits a state of tensile stress. A material of the thin film 2 may be a metal, a metal oxide, an oxide dielectric film, a nitride dielectric film, various ceramic materials, a polymer material, or the like. A stress state and a stress magnitude of the thin film 2 may be implemented by controlling conditions for thin film deposition, such as pressure, current, airflow rate, voltage, and temperature. The thin film 2 is a circular ring distributed on an edge of the circular superlubric slice 1 so that the overall rigidity of the circular graphite slice can be effectively reduced and the edge warps under low tensile stress.

### Embodiment two

As shown in FIG. 2, a structural superlubric device capable of reducing edge friction includes a superlubric slice 1, and a thin film 3 in the shape of a ring of circular arcs and deposited on the superlubric slice 1. The thin film 3 may include a single thin film or multiple thin films and generally exhibits a state of tensile stress. The thin film 3 is in the pattern of a ring of four circular arcs, where two adjacent circular arcs are spaced apart from each other, and the four circular arcs are circumferentially and evenly distributed on an edge of the circular superlubric slice. In this manner, the compressive stress due to a shortened circumferential length when the edge warps can be effectively reduced, the circumferential rigidity of the edge of the graphite slice is reduced, and the edge is easy to warp.

### Embodiment three

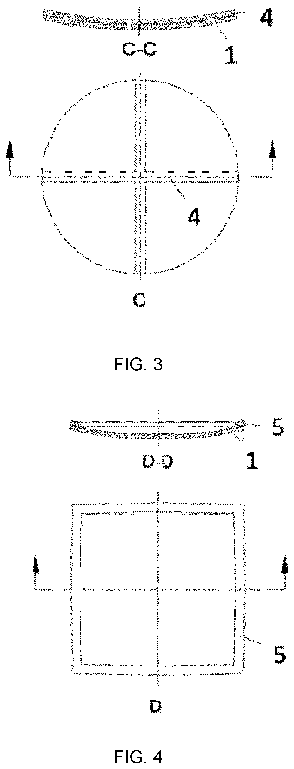

As shown in FIG. 3, a structural superlubric device capable of reducing edge friction includes a superlubric slice 1, and a thin film 4 in the shape of a cross and deposited on the superlubric slice 1. The thin film 4 may include a single thin film or multiple thin films and generally exhibits a state of tensile stress. The thin film 4 is in the pattern of the cross.

### Embodiment four

As shown in FIG. 4, a structural superlubric device capable of reducing edge friction includes a superlubric slice 1, and a thin film 5 in the shape of a square and deposited on the superlubric slice 1. The thin film 5 may include a single thin film or multiple thin films, and generally exhibits a state of tensile stress. The thin film 5 is in the pattern of a square frame distributed on an edge of the circular superlubric slice so that the overall rigidity of the circular superlubric slice is effectively reduced and the edge warps under low tensile stress.

### Embodiment five

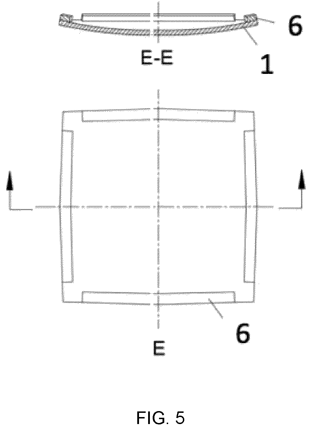

As shown in FIG. 5, a structural superlubric device capable of reducing edge friction includes a superlubric slice 1, and a thin film 6 in the shape of a square of strips and deposited on the superlubric slice 1. The thin film 6 may include a single thin film or multiple thin films, and generally exhibits a state of tensile stress. The thin film 6 is in the pattern of a square of four strips evenly distributed on an edge of the square superlubric slice, where two adjacent strips are spaced apart from each other at a right corner. In this manner, the compressive stress due to a shortened circumferential length of the graphite slice when the edge warps is effectively reduced, the circumferential rigidity of the edge of the superlubric slice is reduced, and the edge is easy to warp.

### Embodiment six

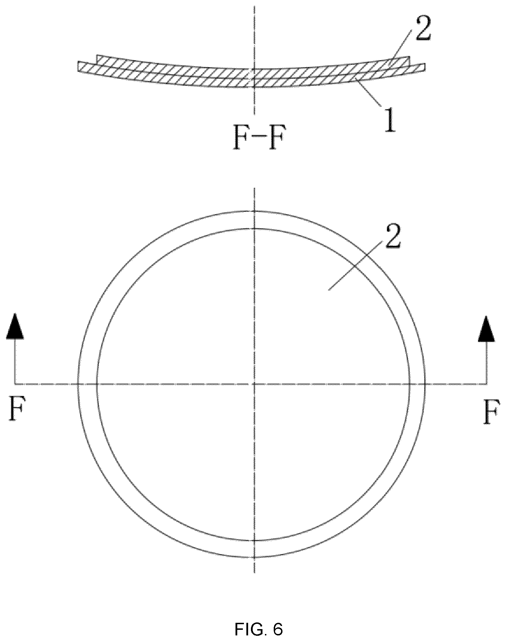

In the embodiment shown in FIG. 6, the thin film 2 covers most of an surface of the superlubric slice 1. With this configuration, the surface of the superlubric slice 1 shrinks under the action of the internal stress of the thin film 2, so that the superlubric slice 1 wraps.

The pattern of the thin film is not limited to these patterns in the embodiments, and other patterns of the thin film that can make the edge warp are within the scope of this patent.

The shape of the superlubric slice is not limited to a circle and a square, and superlubric slices which are in other shapes and whose edges warp based on internal stress are also within the scope of this patent.

## Claims

1. A structural superlubric device, capable of reducing edge friction, comprising a substrate and a superlubric slice (1), **characterized in that** an edge of the superlubric slice (1) warps along a direction opposite to a superlubric surface of the superlubric slice (1) and the edge friction due to an interfacial chemical bond between the edge of the superlubric slice (1) and the substrate is completely eliminated,
wherein the structural superlubric device further comprises a thin film in a direction along which the superlubric slice (1) warps, wherein the thin film is deposited on the superlubric slice (1) and exhibits a state of tensile stress in a direction along which the superlubric slice (1) warps.

2. The structural superlubric device according to claim 1, wherein the thin film comprises a single thin film or a plurality of thin films.

3. The structural superlubric device according to claim 1 or 2, wherein a material of the thin film comprises a metal, a metal oxide, an oxide dielectric film, a nitride dielectric film, various ceramic materials, or a polymer material.

4. The structural superlubric device according to any one of claims 1 to 3, wherein the thin film is in a shape of a circular ring, a ring of circular arcs, a cross, a square, or a square of strips.

5. The structural superlubric device according to any one of claims 1 to 4, wherein the superlubric slice (1) uses graphite, HOPG, graphene, molybdenum disulfide, bismuth, molybdenum, or mica as a substrate.

6. The structural superlubric device according to claim 5, wherein the superlubric slice (1) is an HOPG superlubric slice, or a superlubric slice comprising a single layer or a plurality of layers of two-dimensional material having smooth surfaces in atomic scale.

7. The structural superlubric device according to claim 6, wherein the superlubric slice (1) is a superlubric slice comprising a single layer or a plurality of layers of two-dimensional material having smooth surfaces in atomic scale, and the two-dimensional material is graphene.

## Patentansprüche

1. Strukturelle Supergleitvorrichtung, die in der Lage ist, die Kantenreibung zu reduzieren, und ein Substrat und eine Supergleitscheibe (1) umfasst, **dadurch gekennzeichnet, dass** sich eine Kante der Supergleitscheibe (1) entlang einer Richtung entgegengesetzt zu einer Supergleitoberfläche der Supergleitscheibe (1) verzieht und die Kantenreibung aufgrund einer chemischen Grenzflächenbindung zwischen der Kante der Supergleitscheibe (1) und dem Substrat vollständig beseitigt wird,
wobei die strukturelle Supergleitvorrichtung ferner einen dünnen Film in einer Richtung umfasst, entlang der sich die Supergleitscheibe (1) verzieht, wobei der dünne Film auf der Supergleitscheibe (1) abgeschieden ist und einen Zustand von Zugspannung in einer Richtung zeigt, entlang der sich die Supergleitscheibe (1) verzieht.

2. Strukturelle Supergleitvorrichtung nach Anspruch 1, wobei der dünne Film einen einzelnen dünnen Film oder mehrere dünne Filme umfasst.

3. Strukturelle Supergleitvorrichtung nach Anspruch 1 oder 2, wobei ein Material des dünnen Films ein Metall, ein Metalloxid, einen dielektrischen Oxidfilm, einen dielektrischen Nitridfilm, verschiedene Keramikmaterialien oder ein Polymermaterial umfasst.

4. Strukturelle Supergleitvorrichtung nach einem der Ansprüche 1 bis 3, wobei der dünne Film die Form eines kreisförmigen Rings, eines Rings aus Kreisbögen, eines Kreuzes, eines Quadrats oder eines Quadrats aus Streifen hat.

5. Strukturelle Supergleitvorrichtung nach einem der Ansprüche 1 bis 4, wobei die Supergleitscheibe (1) Graphit, HOPG, Graphen, Molybdändisulfid, Wismut, Molybdän oder Glimmer als Substrat verwendet.

6. Strukturelle Supergleitvorrichtung nach Anspruch 5, wobei die Supergleitscheibe (1) eine HOPG- Supergleitscheibe oder eine Supergleitscheibe ist, die eine einzelne Schicht oder mehrere Schichten aus einem zweidimensionalen Material mit glatten Oberflächen im atomaren Maßstab umfasst.

7. Strukturelle Supergleitvorrichtung nach Anspruch 6, wobei die Supergleitscheibe (1) eine Supergleitscheibe ist, die eine einzelne Schicht oder mehrere Schichten aus einem zweidimensionalen Material mit glatten Oberflächen im atomaren Maßstab umfasst, wobei das zweidimensionale Material Graphen ist.

## Revendications

1. Dispositif superlubrifiant structurel, permettant de réduire un frottement à bords, comprenant un substrat et une tranche superlubrifiante (1), **caractérisé en ce qu'**un bord de la tranche superlubrifiante (1) se déforme selon une direction opposée à une surface superlubrifiante de la tranche superlubrifiante (1) et que le frottement à bords dû à une liaison chimique interfaciale entre le bord de la tranche superlubrifiante (1) et le substrat est complètement éliminé,
dans lequel le dispositif superlubrifiant structurel comprend en outre un film mince dans une direction selon laquelle la tranche superlubrifiante (1) se déforme, le film mince étant déposé sur la tranche superlubrifiante (1) et présentant un état de contrainte en traction dans une direction selon laquelle la tranche superlubrifiante (1) se déforme.

2. Dispositif superlubrifiant structurel selon la revendication 1, dans lequel le film mince comprend un seul film mince ou une pluralité de films minces.

3. Dispositif superlubrifiant structurel selon la revendication 1 ou 2, dans lequel un matériau du film mince comprend un métal, un oxyde métallique, un film diélectrique à base d'oxyde, un film diélectrique à base de nitrure, divers matériaux céramiques ou un matériau polymère.

4. Dispositif superlubrifiant structurel selon l'une quelconque des revendications 1 à 3, dans lequel le film mince présente une forme d'un anneau circulaire, un anneau d'arcs circulaires, une croix, un carré ou un orthogone.

5. Dispositif superlubrifiant structurel selon l'une quelconque des revendications 1 à 4, dans lequel la tranche superlubrifiante (1) utilise le graphite, HOPG, le graphène, le disulfure de molybdène, le bismuth, le molybdène ou la mica comme substrat.

6. Dispositif superlubrifiant structurel selon la revendication 5, dans lequel la tranche superlubrifiante (1) est une tranche superlubrifiante HOPG, ou une tranche superlubrifiante comprenant une seule couche ou une pluralité de couches de matériau bidimensionnel ayant des surfaces lisses à l'échelle atomique.

7. Dispositif superlubrifiant structurel selon la revendication 6, dans lequel la tranche superlubrifiante (1) est une tranche superlubrifiante comprenant une seule couche ou une pluralité de couches de matériau bidimensionnel ayant des surfaces lisses à l'échelle atomique et le matériau bidimensionnel est le graphène.
